# EUROPEAN PATENT SPECIFICATION

(11) **EP 3 965 267 B1**
(45) Date of publication and mention of the grant of the patent: **25.11.2026**
(21) Application number: 21194295.8
(22) Date of filing: 01.09.2021
(51) Int. Cl.: H02K 3/26, H02K 3/28, H02K 3/47

(54) **COIL SUBSTRATE AND MOTOR COIL SUBSTRATE**
SPULENSUBSTRAT UND MOTORSPULENSUBSTRAT
SUBSTRAT DE BOBINE ET SUBSTRAT DE BOBINE DE MOTEUR

(30) Priority: 04.09.2020 JP 2020148920
(43) Date of publication of application: 09.03.2022
(73) Proprietor: Ibiden Co., Ltd., Ogaki-shi, Gifu 503-8604 (JP)
(72) Inventor: Morita, Haruhiko, Ogaki City, Gifu Prefecture (JP); Miwa, Hitoshi, Ogaki City, Gifu Prefecture (JP); Kato, Shinobu, Ogaki-shi, Gifu Prefecture (JP); Yokomaku, Toshihiko, Ogaki City, Gifu Prefecture (JP); Kato, Hisashi, Ogaki-shi, Gifu Prefecture (JP); Hirasawa, Takahisa, Ogaki City, Gifu Prefecture (JP); Muraki, Tetsuya, Ogaki City, Gifu Prefecture (JP); Furuno, Takayuki, Ogaki-shi, Gifu Prefecture (JP)
(74) Representative: Grünecker Patent- und Rechtsanwälte PartG mbB

(56) References cited:
- JP-A- 2020 061 532
- JP-A- 2020 072 551
- JP-A- 2020 114 139
- US-A1- 2009 072 651
- US-A1- 2013 009 511
- US-A1- 2019 245 401
- US-A1- 2020 083 769

## Description

### CROSS-REFERENCE TO RELATED APPLICATIONS

The present application is based upon and claims the benefit of priority to Japanese Patent Application No. 2020-148920, filed September 4, 2020.

### BACKGROUND OF THE INVENTION

### Field of the Invention

The present invention relates to a coil substrate and a motor coil substrate.

### Description of Background Art

Japanese Patent Application Laid-Open Publication No. 2019-140762 describes a motor coil substrate. US 2019/245401 A1 and US 2020/083769 A1 relate to motor coil substrate having a flexible substrate and a plurality of wirings.

### SUMMARY OF THE INVENTION

A coil substrae according to the present invention is defined in claim 1. Further advantageous embodiments are defined in dependent claims.

### BRIEF DESCRIPTION OF THE DRAWINGS

A more complete appreciation of the invention and many of the attendant advantages thereof will be readily obtained as the same becomes better understood by reference to the following detailed description when considered in connection with the accompanying drawings, wherein:
Fig. 1A is a schematic diagram of a motor according to an embodiment of the present invention;
Fig. 1B is a schematic diagram of a motor coil substrate according to an embodiment of the present invention;
Fig. 1C is a plan view of wirings according to an embodiment of the present invention;
Fig. 1D is a plan view of a coil according to an embodiment of the present invention;
Figs. 2A and 2B illustrate a coil substrate according to an embodiment of the present invention;
Fig. 3A is a schematic cross-sectional view of a motor coil substrate according to an embodiment of the present invention;
Fig. 3B illustrates a cross section of a coil substrate according to an embodiment of the present invention;
Fig. 3C is a schematic diagram illustrating overlapping of coils according to an embodiment of the present invention; and
Fig. 3D is a schematic cross-sectional view of a motor coil substrate of a reference example.

### DETAILED DESCRIPTION OF THE EMBODIMENTS

Embodiments will now be described with reference to the accompanying drawings, wherein like reference numerals designate corresponding or identical elements throughout the various drawings.

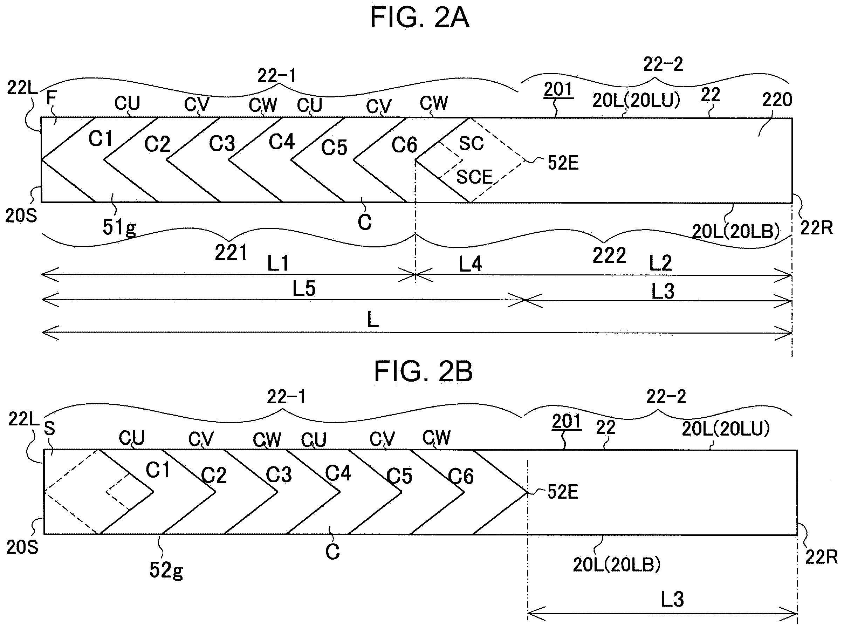

A coil substrate 201 illustrated in Figs. 2A and 2B is prepared. As illustrated in Figs. 2A and 2B, the coil substrate 201 is formed to include: a flexible substrate 22 having a first surface (F) and a second surface (S) on the opposite side with respect to the first surface (F); and coils (C) on the flexible substrate 22. Further, the flexible substrate 22 has short sides (20S) and long sides (20L). The flexible substrate 22 has one end (22L) and the other end (22R) on the opposite side with respect to the one end (22L). The one end (22L) also serves as one of the short sides (20S). The long sides (20L) include an upper side (20LU) and a lower side (20LB) on the opposite side with respect to the upper side (20LU). The number of the coils (C) is M. M is an integer equal to or greater than 2. A maximum value of M is K. In the example of Figs. 2A and 2B, the number of the coils (C1, C2, C3, C4, C5, C6) is 6. The coils (C) are schematically illustrated. Fig. 2A illustrates the coils (C) on the first surface (F), and Fig. 2B illustrates the coils (C) on the second surface (S).

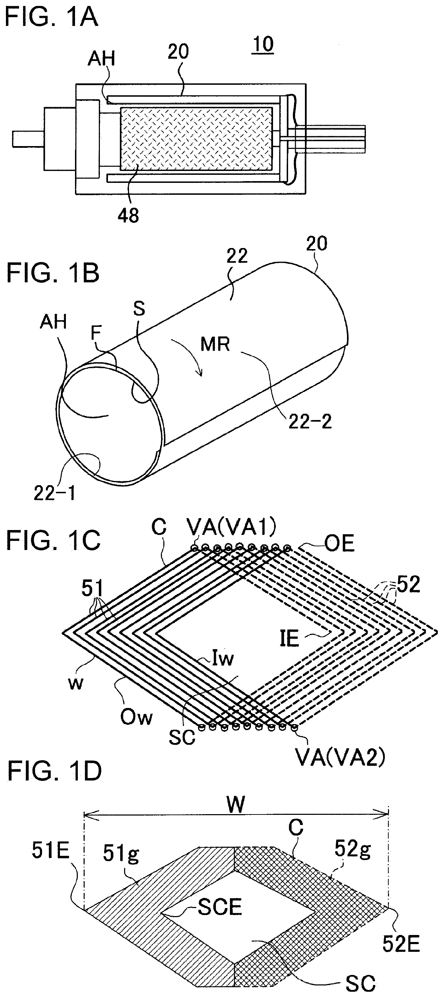

Fig. 1C illustrates an example of a coil (C). The coil (C) is formed of a central space (SC) and wirings (w) surrounding the central space (SC). The wirings (w) have an outer end (OE) and an inner end (IE). The wirings (w) are formed between the outer end (OE) and the inner end (IE). The wirings (w) forming the coil (C) are formed in a spiral shape.

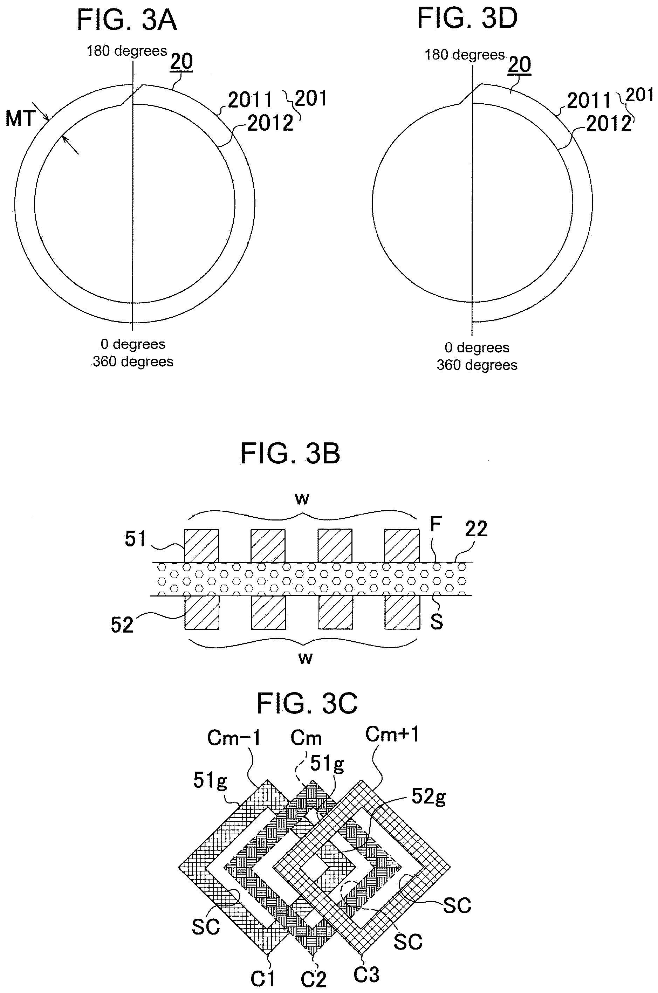

As illustrated in Fig. 1C, the wirings (w) are formed to include multiple first circuits 51, multiple second circuits 52, and multiple via conductors (VA). As illustrated in Fig. 3B, the first circuits 51 are formed on the first surface (F), and the second circuits 52 are formed on the second surface (S). The via conductors (VA) penetrate the flexible substrate 22. The first circuits 51 and the second circuits 52 are connected via the via conductors (VA). One first circuit 51, one second circuit 52 and one via conductor (VA) form substantially a 1-turn coil. Among the wirings (w) that form one turn, the first circuit 51 is close to the one end (22L) and the second circuit 52 is close to the other end (22R). The multiple via conductors (VA) are divided into first via conductors (VA1) and second via conductors (VA2). The first via conductors (VA1) are close to the upper side (20LU), and the second via conductors (VA2) are close to the lower side (20LB). The first circuits 51, the second circuits 52, and the via conductors (VA) are connected in the order of the first circuits 51, the second via conductors (VA2), the second circuits 52, and the first via conductors (VA1). Wirings (w) forming adjacent turns are connected via the first via conductors (VA1).

In Fig. 1D, the wirings (w) are grouped. By grouping the first circuits 51, a first circuit group (51g) is formed. By grouping the second circuits 52, a second circuit group (52g) is formed. The coils (C) in Figs. 2A and 2B are drawn using the first circuit groups (51g) and the second circuit groups (52g).

As illustrated in Fig. 1D, the coil (C) has a one end (51E) and the other end (52E). The one end (51E) of the coil (C) is closest to the one end (22L) of the flexible substrate 22. The other end (52E) of the coil (C) is closest to the other end (22R) of the flexible substrate 22. A distance between the one end (51E) of the coil (C) and the other end (52E) of the coil (C) is a width (W) of the coil (C). The coils (C) have substantially the same width.

The coils (C) of the embodiment are formed using a technology for a printed wiring board. The wirings (w) forming the coils (C) are formed by plating. Or, the wirings (w) forming the coils (C) are formed by etching a copper foil. The wirings (w) forming the coils (C) are formed using a semi-additive method, an M-Sap method, or a subtractive method.

The wirings (w) forming the coils (C) are formed using a technology for a printed wiring board. Therefore, a cross-sectional shape of each of the wirings (w) is substantially rectangular. According to the embodiment, a space factor of the coils can be increased.

The multiple coils (C) formed on the flexible substrate 22 are simultaneously formed. For example, the multiple coils (C) are formed on the flexible substrate 22 using a common alignment mark. Therefore, positions of the coils (C) are related to each other.

Fig. 3C illustrates overlapping of the m-th coil (Cm), the (m + 1)-th coil (Cm + 1), and the (m - 1)-th coil (Cm - 1). When m is 2, the m-th coil (Cm) is the second coil (C2), the (m + 1)-th coil (Cm + 1) is the third coil (C3), and the (m -1)-th coil (Cm -1) is the first coil (C1). In the example of Fig. 3C, m is 2.

The second circuit group (52g) of the (m - 1)-th coil (Cm - 1) is positioned below the central space (SC) of the m-th coil (Cm), and the first circuit group (51g) of (m + 1)-th coil (Cm + 1) is positioned above the central space (SC) of the m-th coil (Cm). In Fig. 3C, an outer periphery of the central space (SC) of the m-th coil (Cm) is drawn using a dotted line. A density of the wirings (w) forming the coils (C) can be increased. A space factor of the coils (C) can be increased. A torque of a motor can be increased.

The coils (C) include U-phase coils (CU), V-phase coils (CV), and W-phase coils (CW). The U-phase coils (CU), the V-phase coils (CV), and W-phase coil (CW) are in the order of a U-phase coil (CU), a V-phase coil (CV), and a W-phase coil (CW). The coil (C) closest to the one end (22L) is a U-phase coil (CU).

The coil substrate 201 is formed of a single flexible substrate 22. The coils (C) are formed along the long sides (20L) of the flexible substrate 22. The coil (C) closest to the one end (22L) is the first coil (C1). The coil closest to the other end (22R) is the K-th coil (CK). The coils (C) are formed in order from the first coil (C1) to the K-th coil (CK). The coils (C) are formed in one row from the one end (22L) to the other end (22R) of the flexible substrate 22. However, as illustrated in Figs. 2A and 2B, the coils (C) are not evenly positioned. The coils (C) are not formed in a predetermined region 220 including the other end (22R). The predetermined region 220 is referred to as a predetermined interval 220. The predetermined interval 220 is formed between the K-th coil (CK) and the other end (22R). The flexible substrate 22 forming the predetermined interval 220 is a sub portion (22-2). The flexible substrate 22 excluding the sub portion (22-2) is a main portion (22-1). The flexible substrate 22 is formed of the main portion (22-1) and the sub portion (22-2). The sub portion (22-2) extends from the main portion (22-1). The coils (C) are formed on the main portion (22-1). The coils (C) are not formed on the sub portion (22-2).

In the example of Figs. 2A and 2B, the 6 coils (C) are positioned from the one end (22L) toward the other end (22R). The coils (C) from the first coil (C1) to the sixth coil (C6) are formed on the main portion (22-1).

As illustrated in Figs. 2A and 2B, a length of the flexible substrate 22 is L. A length of the main portion (22-1) is L5. The length (L5) is a distance between the one end (22L) and the other end (52E) of the K-th coil (CK). A length of the sub portion (22-2) is L3. The length (L3) is a distance between the other end (52E) of the K-th coil (CK) and the other end (22R) of the flexible substrate 22. The length (L) is a sum of the length (L5) and the length (L3). Since the flexible substrate 22 of the embodiment has the predetermined interval 220, the length (L) of the coil substrate 201 can be freely adjusted.

By winding the coil substrate 201, a motor coil substrate 20 illustrated in Fig. 1B is obtained. For example, the coil substrate 201 is wound in a tubular shape. The motor coil substrate 20 is wound around a hollow space (AH). For example, the motor coil substrate 20 has a tubular shape. The number of windings (N) is 2 or more and 3 or less. N is 2 or larger. Fig. 1B is a schematic diagram.

When the coil substrate 20 formed of the main portion (22-1) and the sub portion (22-2) is wound, as illustrated in Fig. 1B, the sub portion (22-2) is wound on an outer side of the main portion (22-1).

As illustrated in Fig. 1B, the flexible substrate 22 is wound for 2 or more turns. When the flexible substrate 22 is observed from a viewpoint of the motor coil substrate 20, the flexible substrate 22 can be considered as a collection of flexible substrates that respectively form the turns. In the motor coil substrate 20, the flexible substrate positioned on the innermost side is the flexible substrate of the first turn. The flexible substrate of the first turn is a first flexible substrate 221. The flexible substrate of the second turn is a second flexible substrate 222. The second flexible substrate 222 extends from the first flexible substrate 221. Further, the second flexible substrate 222 is wound around the first flexible substrate 221. In this way, the flexible substrate 22 that forms the motor coil substrate 20 is formed of the first to N-th flexible substrates. The N-th flexible substrate (22N) is the flexible substrate positioned on the outermost side. The N-th flexible substrate (22N) extends from the (N - 1)-th flexible substrate (22(N - 1)). The N-th flexible substrate (22N) is wound around the (N - 1)-th flexible substrate (22(N - 1)).

A length (predetermined length) of the flexible substrate for one turn is L1. The length (L1) is illustrated in Fig. 2A. As illustrated in Fig. 2A, the length (L1) is represented by a length of the first flexible substrate 221. Or, the length (L1) is represented by an average value of the lengths of the flexible substrates that respectively form the turns. By adjusting the predetermined interval 220, L/L1 can be freely adjusted. For example, L/L1 can be adjusted to an integer equal to or greater than 2. In that case, the lengths of the flexible substrates that are respectively formed in the turns are substantially equal to each other. The N-th flexible substrate (22N) substantially completely covers the (N - 1)-th flexible substrate (22(N - 1)). L, L1, and N satisfy the following relationship 1: Relationship 1: $L = N \times L 1$

In the example of Fig. 1B, N is 2. The coil substrate 201 is wound for exactly 2 turns. The length (L) of the flexible substrate 22 is 2×L1.

Coils (C) are formed on each flexible substrate. Each coil substrate is formed by each flexible substrate and the coils (C) on the each flexible substrate. For example, a first coil substrate 2011 is formed by the first flexible substrate 221 and the coils (C) on the first flexible substrate 221. The N-th coil substrate (201N) is formed by the N-th flexible substrate (22N) and the coils (C) on the N-th flexible substrate (22N). In the first to (N - 1)-th coil substrates, the coils (C) on each flexible substrate are substantially evenly positioned. On the other hand, in the N-th coil substrate (201N), the coils (C) on the N-th flexible substrate (22N) are not evenly positioned. The N-th flexible substrate (22N) has the predetermined interval 220 that includes the other end (22R). Therefore, by adjusting a length of the predetermined interval 220, a length (LN) of the N-th flexible substrate (22N) can be freely adjusted.

In the example of Figs. 2A and 2B, the flexible substrate 22 is formed of the first flexible substrate 221 and the second flexible substrate 222 that extends from the first flexible substrate 221. The first to fourth coils (C1, C2, C3, C4) are formed on the first flexible substrate 221. The fifth and sixth coils (C5, C6) are formed on the first and second flexible substrates (221, 222). The length of the first flexible substrate 221 is L1. The length (L1) of the first flexible substrate 221 and the predetermined length are equal to each other. In the example of Figs. 2A and 2B, the length (L1) is a distance between the one end (22L) of the flexible substrate 22 and the other end (52E) of the fourth coil (C4). A length of the second flexible substrate 222 is L2. In the example of Figs. 2A and 2B, the length (L2) is a distance between the other end (22R) of the flexible substrate 22 and the other end (52E) of the fourth coil (C4). The length (L2) of the second flexible substrate 222 and the predetermined length (L1) are substantially equal to each other.

The length (L3) of the sub portion (22-2) and the length (LN) of the N-th flexible substrate (22N) are compared. In Figs. 2A and 2B, the length (LN) of the N-th flexible substrate (22N) is the length (L2). The K-th coil (CK) is formed on the N-th flexible substrate (22N). The length (L3) of the sub portion (22-2) is a distance between the other end (52E) of the K-th coil (CK) and the other end (22R) of the flexible substrate 22. Therefore, the length (LN) of the N-th flexible substrate (22N) is longer than the length of the sub portion (22-2) (the length of the predetermined interval) (L3). The length (L3) of the predetermined interval is larger than the width (W) of each of the coils (C). The length (L3) of the predetermined interval is about a half of the predetermined length (L1). The N-th coil substrate 20N can have lightness and strength.

As illustrated in Fig. 1A, a motor 10 is obtained by positioning a magnet 48 inside the motor coil substrate 20. Fig. 1A is a schematic diagram. The motor coil substrate 20 is positioned around the magnet 48 via the hollow space (AH). An example of the motor 10 is a brushless motor. In the embodiment, the magnet 48 rotates. However, it is also possible that the motor coil substrate 20 rotates. A rotation direction (MR) of the motor 10 is illustrated in Fig. 1B.

Fig. 3A illustrates a cross section of the motor coil substrate 20 obtained by cutting the motor 10 in a plane parallel to the rotation direction (MR) of the motor 10. Fig. 3A is a schematic diagram. In Fig. 3A, the coils (C) are omitted and only the flexible substrate 22 is drawn.

As illustrated in Fig. 3A, the motor coil substrate 20 has a thickness (MT), and the thickness (MT) of the motor coil substrate 20 is measured in the cross section. The thickness (MT) of the motor coil substrate 20 includes the flexible substrates positioned in the turns. In the embodiment, the N-th flexible substrate (22N) has the predetermined interval of 220. Therefore, the length (LN) of the N-th flexible substrate (22N) and the predetermined length (L1) are substantially the same. The lengths of flexible substrates of the turns are substantially equal to each other. Therefore, by adjusting the length (L3) of the predetermined interval, the thickness (MT) of the motor coil substrate 20 can be made substantially equal from 0 degrees to 360 degrees. The motor coil substrate 20 can be reliably fixed in the motor 10. Roundness of the motor coil substrate 20 can be increased. The roundness is observed in the cross section of the motor coil substrate 20. The motor coil substrate 20 smoothly rotates. When the motor coil substrate 20 rotates, energy loss can be reduced. Eccentricity is unlikely to occur.

In the example of Fig. 3A, the motor coil substrate 20 is manufactured by winding the coil substrate 201 illustrated in Figs. 2A and 2B. The motor coil substrate 20 illustrated in Fig. 3A is formed of the first coil substrate 2011 and a second coil substrate 2012 wound around the first coil substrate 2011. And, the length (L1) of the first flexible substrate 221 and the length (L2) of the second flexible substrate 222 are equal to each other. Therefore, the coil substrate 201 is wound for exactly 2 turns. The thickness (MT) of the motor coil substrate 20 is substantially even.

When the flexible substrate 22 does not have the predetermined interval 220, the length (LN) of the N-th flexible substrate (22N) and the predetermined (L1) are unlikely to match each other. In that case, the length (LN) is shorter than the length (L1). Such a coil substrate is a reference example. By winding the coil substrate of the reference example, a motor coil substrate of the reference example is manufactured. Fig. 3D illustrates a schematic diagram of a cross section of the motor coil substrate of the reference example. As illustrated in Fig. 3D, the thickness (MT) of the motor coil substrate 20 is partially different. When the motor coil substrate 20 of Fig. 3D rotates, eccentricity is likely to occur.

Fig. 1B of Japanese Patent Application Laid-Open Publication No. 2019-140762 illustrates a developed view of a motor coil substrate. According to the figure, it is thought that coils are evenly positioned on an insulating substrate. Fig. 3D of Japanese Patent Application Laid-Open Publication No. 2019-140762 illustrates a cross section of the motor coil substrate. According to the figure, it is conceivable that an outer diameter (D1) differs depending on a measurement location.

A coil substrate according to an embodiment of the present invention includes: a flexible substrate having one end and the other end on the opposite side with respect to the one end; and multiple coils formed on the flexible substrate. The number of the coils is K, the coils are formed substantially in a row between the one end and the other end. The first coil is close to the one end. A predetermined distance is formed between the K-th coil and the other end. K is an integer equal to or greater than 2.

According to an embodiment of the present invention, a coil substrate is formed of the flexible substrate having the one end and the other end and the multiple coils on the flexible substrate. The number of the coils is K, and the predetermined interval is formed between the K-th coil and the other end. Therefore, the length of the coil substrate can be freely adjusted by adjusting the predetermined interval.

A motor coil substrate can be manufactured by winding a coil substrate according to an embodiment of the present invention. A length of the flexible substrate is L. The number of turns the coil substrate is wound is N. In the motor coil substrate, the flexible substrate positioned on an innermost side is a first flexible substrate. The flexible substrate positioned on an outermost side is an N-th flexible substrate. The N-th flexible substrate extends from an (N - 1)-th flexible substrate. And, the N-th flexible substrate is wound around the (N - 1)-th flexible substrate. A length of one turn of the flexible substrate is L1. By adjusting the predetermined interval, L/L1 can be adjusted. For example, L/L1 can be adjusted to an integer equal to or greater than 2. In that case, the lengths of the flexible substrates that are respectively formed in the turns are substantially equal to each other. The N-th flexible substrate substantially completely covers the (N - 1)-th flexible substrate.

A motor is manufactured using a motor coil substrate according to an embodiment of the present invention and a magnet. When the motor coil substrate is cut in a plane parallel to a rotation direction of the motor, a cross section of the motor coil substrate is formed. The motor coil substrate has a thickness. The thickness of the motor coil substrate is measured in the cross section. The thickness of the motor coil substrate includes the flexible substrates positioned in the turns. Therefore, by adjusting the predetermined interval, the thickness of the motor coil substrate can be made substantially the same from 0 degrees to 360 degrees. Roundness of the motor coil substrate can be increased. The roundness is observed in the cross section of the motor coil substrate. The motor coil substrate smoothly rotates. When the motor coil substrate rotates, energy loss can be reduced. Eccentricity is unlikely to occur.

Obviously, numerous modifications and variations of the present invention are possible in light of the above teachings. It is therefore to be understood that within the scope of the appended claims, the invention may be practiced otherwise than as specifically described herein.

## Claims

1. A coil substrate, comprising:
a flexible substrate (22) having a first end (22L) and a second end (22R) on an opposite side with respect to the first end (22L); and
a plurality of coils (C) formed on the flexible substrate (22) such that the plurality of coils (C) is positioned substantially in a row between the first end (22L) and second end (22R) of the flexible substrate (22),
wherein the plurality of coils (C) is formed such that a number of coils of the plurality of coils (C) is K and that the plurality of coils (C) includes a first coil (C1) positioned close to the first end (22L) and a K-th coil (CK) positioned to form a distance between the K-th coil (CK) and the second end (22R), where K is an integer equal to or greater than 2,
wherein the plurality of coils (C) is formed such that each of the coils has a center space and a plurality of wirings (w) surrounding the center space and that the plurality of wirings (w) includes a plurality of first circuits (51) formed on a first surface (F) of the flexible substrate (22), a plurality of second circuits (52) formed on a second surface (S) of the flexible substrate (22) on an opposite side with respect to the first surface (F), and a plurality of via conductors (VA) penetrating through the flexible substrate (22) and connecting the first circuits (51) and the second circuits (52), the plurality of wirings (w) in each of the coils (C) is formed such that one first circuit, one via conductor, and one second circuit form a 1-turn coil, and the plurality of coils (C) is formed such that the plurality of second circuits (52) in a (m - 1)-th coil is positioned below the center space of a m-th coil and that the plurality of first circuits in a (m + 1)-th coil is positioned above the center space of the m-th coil, where m is an integer equal to or greater than 2.

2. The coil substrate according to claim 1, wherein the flexible substrate (22) includes a main portion (22-1) and a sub portion (22-2) extending from the main portion (22-1) such that the sub portion (22-2) forms an interval and that the plurality of coils (C) is not formed on the sub portion (22-2) of the flexible substrate (22).

3. The coil substrate according to claim 2, wherein the flexible substrate (22) is a single flexible substrate comprising the main portion (22-1) and sub portion (22-2) forming parts of the single flexible substrate.

4. The coil substrate according to claim 1, wherein the plurality of coils (C) includes a U-phase coil, a V-phase coil, and a W-phase coil.

5. A motor coil substrate, comprising:
the coil substrate (201) of any one claim 1, 2, or 4 wound for N turns,
wherein the flexible substrate (22) has a length that is N times a length of one turn of the N turns and that a length of the sub portion (22-2) is shorter than the length of one turn of the N turns, where N is an integer equal to or greater than 2.

6. The motor coil substrate according to claim 5, wherein the flexible substrate (22) includes a first flexible substrate (221) and a second flexible substrate (222) extending from the first flexible substrate (221) such that the first flexible substrate (221) is a part of the main portion (22-1) of the flexible substrate (22), that the sub portion (22-2) of the flexible substrate (22) is a part of the second flexible substrate (222), and that the second flexible substrate (222) is wound around the first flexible substrate (221), and the flexible substrate (22) is formed such that a length of the first flexible substrate (221) is substantially equal to the length of one turn of the N turns, that a length of the second flexible substrate (222) is substantially equal to the length of one turn of the N turns, and that the K-th coil (CK) is formed on the second flexible substrate (222).

7. The motor coil substrate according to claim 6, wherein the flexible substrate (22) is formed such that the interval is larger than a width of each of the coils (C).

8. The motor coil substrate according to claim 6, wherein the flexible substrate (22) is formed such that the interval is about a half of the length of one turn of the N turns.

## Patentansprüche

1. Spulensubstrat, umfassend:
ein flexibles Substrat (22), das ein erstes Ende (22L) und ein zweites Ende (22R) auf einer dem ersten Ende (22L) gegenüberliegenden Seite aufweist; und
eine Vielzahl von Spulen (C), die auf dem flexiblen Substrat (22) derart ausgebildet sind, dass die Vielzahl von Spulen (C) im Wesentlichen in einer Reihe zwischen dem ersten Ende (22L) und dem zweiten Ende (22R) des flexiblen Substrats (22) angeordnet ist,
wobei die Vielzahl von Spulen (C) derart ausgebildet ist, dass eine Anzahl von Spulen der Vielzahl von Spulen (C) K beträgt und dass die Vielzahl von Spulen (C) eine erste Spule (C1), die nahe bei dem ersten Ende (22L) angeordnet ist, und eine K-te Spule (CK) umfasst, die derart angeordnet ist, dass zwischen der K-ten Spule (CK) und dem zweiten Ende (22R) ein Abstand gebildet ist, wobei K eine ganze Zahl gleich oder größer als 2 ist,
wobei die Vielzahl von Spulen (C) derart ausgebildet ist, dass jede der Spulen einen zentralen Freiraum und eine Vielzahl von Leiterbahnen (w), die den zentralen Freiraum umgeben, aufweist und dass die Vielzahl von Leiterbahnen (w) eine Vielzahl erster Schaltungen (51), die auf einer ersten Oberfläche (F) des flexiblen Substrats (22) ausgebildet sind, eine Vielzahl zweiter Schaltungen (52), die auf einer zweiten Oberfläche (S) des flexiblen Substrats (22) auf einer der ersten Oberfläche (F) gegenüberliegenden Seite ausgebildet sind, und eine Vielzahl von Durchkontaktierungsleitern (VA), die das flexible Substrat (22) durchdringen und die ersten Schaltungen (51) und die zweiten Schaltungen (52) verbinden, umfasst, wobei die Vielzahl von Leiterbahnen (w) in jeder der Spulen (C) derart ausgebildet ist, dass eine erste Schaltung, ein Durchkontaktierungsleiter und eine zweite Schaltung eine Spule mit einer Windung bilden, und die Vielzahl von Spulen (C) derart ausgebildet ist, dass die Vielzahl zweiter Schaltungen (52) in einer (m - 1)-ten Spule unterhalb des zentralen Freiraums einer m-ten Spule angeordnet ist und dass die Vielzahl erster Schaltungen in einer (m + 1)-ten Spule oberhalb des zentralen Freiraums der m-ten Spule angeordnet ist, wobei m eine ganze Zahl gleich oder größer als 2 ist.

2. Spulensubstrat nach Anspruch 1, wobei das flexible Substrat (22) einen Hauptabschnitt (22-1) und einen Unterabschnitt (22-2) umfasst, der sich von dem Hauptabschnitt (22-1) derart erstreckt, dass der Unterabschnitt (22-2) einen Abstand bildet und dass die Vielzahl von Spulen (C) nicht auf dem Unterabschnitt (22-2) des flexiblen Substrats (22) ausgebildet ist.

3. Spulensubstrat nach Anspruch 2, wobei das flexible Substrat (22) ein einziges flexibles Substrat ist, das den Hauptabschnitt (22-1) und den Unterabschnitt (22-2) umfasst, die Teile des einzigen flexiblen Substrats bilden.

4. Spulensubstrat nach Anspruch 1, wobei die Vielzahl von Spulen (C) eine U-Phasen-Spule, eine V-Phasen-Spule und eine W-Phasen-Spule umfasst.

5. Motorspulensubstrat, umfassend:
das Spulensubstrat (201) nach einem der Ansprüche 1, 2 oder 4, das mit N Windungen gewickelt ist,
wobei das flexible Substrat (22) eine Länge aufweist, die das N-Fache einer Länge einer Windung der N Windungen beträgt, und wobei eine Länge des Unterabschnitts (22-2) kürzer als die Länge einer Windung der N Windungen ist, wobei N eine ganze Zahl gleich oder größer als 2 ist.

6. Motorspulensubstrat nach Anspruch 5, wobei das flexible Substrat (22) ein erstes flexibles Substrat (221) und ein zweites flexibles Substrat (222) umfasst, das sich von dem ersten flexiblen Substrat (221) derart erstreckt, dass das erste flexible Substrat (221) ein Teil des Hauptabschnitts (22-1) des flexiblen Substrats (22) ist, dass der Unterabschnitt (22-2) des flexiblen Substrats (22) ein Teil des zweiten flexiblen Substrats (222) ist und dass das zweite flexible Substrat (222) um das erste flexible Substrat (221) gewickelt ist, und wobei das flexible Substrat (22) derart ausgebildet ist, dass eine Länge des ersten flexiblen Substrats (221) im Wesentlichen gleich der Länge einer Windung der N Windungen ist, dass eine Länge des zweiten flexiblen Substrats (222) im Wesentlichen gleich der Länge einer Windung der N Windungen ist und dass die K-te Spule (CK) auf dem zweiten flexiblen Substrat (222) ausgebildet ist.

7. Motorspulensubstrat nach Anspruch 6, wobei das flexible Substrat (22) derart ausgebildet ist, dass der Abstand größer als eine Breite jeder der Spulen (C) ist.

8. Motorspulensubstrat nach Anspruch 6, wobei das flexible Substrat (22) derart ausgebildet ist, dass der Abstand ungefähr die Hälfte der Länge einer Windung der N Windungen beträgt.

## Revendications

1. Substrat de bobine, comprenant :
un substrat flexible (22) ayant une première extrémité (22L) et une deuxième extrémité (22R) située sur un côté opposé par rapport à la première extrémité (22L) ; et
une pluralité de bobines (C) formées sur le substrat flexible (22) de telle sorte que la pluralité de bobines (C) est disposée sensiblement en rangée entre la première extrémité (22L) et la deuxième extrémité (22R) du substrat flexible (22),
dans lequel la pluralité de bobines (C) est formée de telle sorte qu'un nombre de bobines de la pluralité de bobines (C) est K et que la pluralité de bobines (C) comprend une première bobine (C1) disposée à proximité de la première extrémité (22L) et une K-ième bobine (CK) disposée de manière à former une distance entre la K-ième bobine (CK) et la deuxième extrémité (22R), K étant un entier supérieur ou égal à 2,
dans lequel la pluralité de bobines (C) est formée de telle sorte que chacune des bobines présente un espace central et une pluralité de pistes conductrices (w) entourant l'espace central, et que la pluralité de pistes conductrices (w) comprend une pluralité de premiers circuits (51) formés sur une première surface (F) du substrat flexible (22), une pluralité de deuxièmes circuits (52) formés sur une deuxième surface (S) du substrat flexible (22) située sur un côté opposé par rapport à la première surface (F), et une pluralité de conducteurs de via (VA) traversant le substrat flexible (22) et reliant les premiers circuits (51) et les deuxièmes circuits (52), la pluralité de pistes conductrices (w) dans chacune des bobines (C) étant formée de telle sorte qu'un premier circuit, un conducteur de via et un deuxième circuit forment une bobine à un tour, et la pluralité de bobines (C) étant formée de telle sorte que la pluralité de deuxièmes circuits (52) dans une (m - 1)-ième bobine est disposée au-dessous de l'espace central d'une m-ième bobine et que la pluralité de premiers circuits dans une (m + 1)-ième bobine est disposée au-dessus de l'espace central de la m-ième bobine, m étant un entier supérieur ou égal à 2.

2. Substrat de bobine selon la revendication 1, dans lequel le substrat flexible (22) comprend une partie principale (22-1) et une sous-partie (22-2) s'étendant à partir de la partie principale (22-1) de telle sorte que la sous-partie (22-2) forme un intervalle et que la pluralité de bobines (C) n'est pas formée sur la sous-partie (22-2) du substrat flexible (22).

3. Substrat de bobine selon la revendication 2, dans lequel le substrat flexible (22) est un substrat flexible unique comprenant la partie principale (22-1) et la sous-partie (22-2) formant des parties du substrat flexible unique.

4. Substrat de bobine selon la revendication 1, dans lequel la pluralité de bobines (C) comprend une bobine de phase U, une bobine de phase V et une bobine de phase W.

5. Substrat de bobine de moteur, comprenant :
le substrat de bobine (201) selon l'une quelconque des revendications 1, 2 ou 4, enroulé sur N tours,
dans lequel le substrat flexible (22) présente une longueur qui est égale à N fois une longueur d'un tour parmi les N tours et dans lequel une longueur de la sous-partie (22-2) est inférieure à la longueur d'un tour parmi les N tours, N étant un entier supérieur ou égal à 2.

6. Substrat de bobine de moteur selon la revendication 5, dans lequel le substrat flexible (22) comprend un premier substrat flexible (221) et un deuxième substrat flexible (222) s'étendant à partir du premier substrat flexible (221) de telle sorte que le premier substrat flexible (221) est une partie de la partie principale (22-1) du substrat flexible (22), que la sous-partie (22-2) du substrat flexible (22) est une partie du deuxième substrat flexible (222), et que le deuxième substrat flexible (222) est enroulé autour du premier substrat flexible (221), et dans lequel le substrat flexible (22) est formé de telle sorte qu'une longueur du premier substrat flexible (221) est sensiblement égale à la longueur d'un tour parmi les N tours, qu'une longueur du deuxième substrat flexible (222) est sensiblement égale à la longueur d'un tour parmi les N tours, et que la K-ième bobine (CK) est formée sur le deuxième substrat flexible (222).

7. Substrat de bobine de moteur selon la revendication 6, dans lequel le substrat flexible (22) est formé de telle sorte que l'intervalle est supérieur à une largeur de chacune des bobines (C).

8. Substrat de bobine de moteur selon la revendication 6, dans lequel le substrat flexible (22) est formé de telle sorte que l'intervalle est égal à environ la moitié de la longueur d'un tour parmi les N tours.
